# DEMANDE DE BREVET EUROPEEN

(11) **EP 3 961 721 A1**
(43) Date de publication de la demande: **02.03.2022**
(21) Numéro de dépôt: 21188650.2
(22) Date de dépôt: 30.07.2021
(51) Int. Cl.: H01L 29/66, H01L 29/786, H01L 29/78, H01L 29/165

(54) **PROCEDE AMELIORE D'ENRICHISSEMENT GERMANIUM AUTOUR DU CANAL D'UN TRANSISTOR**

(30) Priorité: 31.08.2020 FR 2008832
(71) Demandeur: Commissariat à l'énergie atomique et aux énergies alternatives, 75015 Paris (FR)
(72) Inventeur: NIEBOJEWSKI, Heimanu, 38054 GRENOBLE CEDEX 09 (FR); PLANTIER, Christophe, 38054 GRENOBLE CEDEX 09 (FR); REBOH, Shay, 38054 GRENOBLE CEDEX 09 (FR)
(74) Mandataire: Brevalex

(57) **Abrégé**

Réalisation d'une structure de transistor comprenant dans cet ordre :
- former sur la couche semi-conductrice superficielle et de part et d'autre d'espaceurs isolants, des blocs semi-conducteurs en SiₓGe₁₋ₓ, les blocs semi-conducteurs ayant des facettes latérales,
- croissance d'une couche à base de silicium sur les blocs semi-conducteurs, de manière à remplir des cavités situées entre lesdites facettes et lesdits espaceurs isolants,
- oxydation thermique pour effectuer un enrichissement en germanium de portions semi-conductrices (31a, 31b) de la couche semi-conductrice superficielle (12) disposées de part et d'autre des espaceurs.

## Description

### DOMAINE TECHNIQUE ET ÉTAT DE LA TECHNIQUE ANTÉRIEURE

La présente description concerne le domaine des structures de transistors, et plus particulièrement celles dotées d'une zone de canal subissant une déformation ou contrainte mécanique.

Par déformation mécanique on entend un matériau qui a son ou ses paramètre(s) de maille cristalline allongé(s) ou écourté(s).

Dans le cas où le paramètre de maille déformé est plus important que le paramètre dit « naturel » d'un matériau cristallin, celui-ci est dit en déformation en tension. Lorsque le paramètre de maille déformé est plus petit que le paramètre de maille naturel, le matériau est dit en déformation compressive ou en compression.

A ces états de déformation mécanique, on associe des états de contraintes mécaniques. Pour autant, il est également commun de se référer à ces états de déformation comme des états de contraintes mécaniques. Dans la suite de la présente demande, cette notion de déformation (« strain » selon la terminologie anglo-saxonne) sera désignée de façon générique par le terme « contrainte ».

Une contrainte appliquée à un matériau semi-conducteur induit une modification de la maille cristalline et donc de sa structure de bande, dont va découler une modification de la mobilité des porteurs dans ce matériau.

La mobilité des électrons est augmentée (respectivement diminuée) par une contrainte longitudinale en tension (respectivement en compression) du matériau semi-conducteur dans lequel ils transitent alors que la mobilité des trous sera augmentée (respectivement diminuée) lorsque le semi-conducteur est en compression (respectivement en tension) dans la direction longitudinale.

Pour améliorer les performances des transistors de type P, il est connu de prévoir une structure de canal formée dans une couche superficielle contrainte en compression d'un substrat de type semi-conducteur isolant.

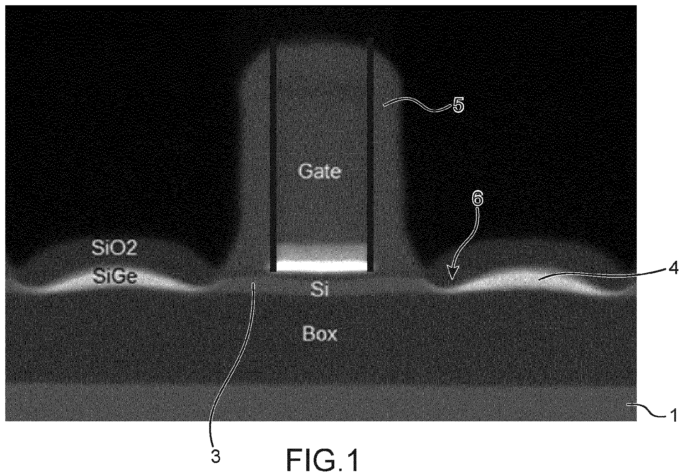

Le document US 2008/0042209 A1 présente ainsi un procédé de réalisation sur un substrat 1 SOI d'un transistor ayant une structure de canal formée dans une couche superficielle en silicium que l'on vient mettre en contrainte. Cette mise en contrainte est réalisée par le biais d'une croissance de SiGe sur la couche superficielle puis en effectuant un enrichissement en Germanium de régions de la couche superficielle de part et d'autre de la région de canal. A l'issue de cet enrichissement en Germanium, des zones de pincement 6 où l'épaisseur de matériau semi-conducteur est réduite peuvent avoir tendance à se former de part et d'autre d'une région 3 de la couche superficielle située en regard de la grille et des espaceurs 5. De telles zones de pincement 6 entre cette région 3 et des portions 4 enrichies en Germanium sont illustrées sur la figure 1 et posent plusieurs problèmes.

Elles peuvent tout d'abord limiter voire empêcher la transmission de la contrainte vers la région de canal.

Elles peuvent également gêner la formation ultérieure de blocs de source et de drain en étant à l'origine de phénomènes de démouillage d'une épaisseur semi-conductrice que l'on réalise ensuite typiquement par épitaxie pour former ces blocs.

Elles peuvent enfin créer une discontinuité électrique de blocs de source et de drain vers le canal ou tout du moins augmenter les résistances d'accès au canal.

Il se pose le problème de trouver un nouveau procédé de réalisation d'une structure de transistor contraint et qui soit amélioré vis-à-vis d'inconvénients énoncés ci-dessus.

### EXPOSÉ DE L'INVENTION

Un mode de réalisation de la présente invention prévoit un procédé de réalisation d'une structure de transistor comprenant, dans cet ordre :
- fournir un bloc de grille et des espaceurs isolants de part et d'autre du bloc de grille sur une région donnée d'une couche semi-conductrice superficielle d'un substrat de type semi-conducteur sur isolant, la couche semi-conductrice superficielle étant à base d'un premier matériau semi-conducteur, en particulier du Si ou du Si₁₋ₐGeₐ avec a > 0, la région donnée étant apte à accueillir une structure de canal dudit transistor en regard dudit bloc de grille,
- former sur la couche semi-conductrice superficielle et de part et d'autre des espaceurs, des blocs semi-conducteurs par croissance d'un deuxième matériau semi-conducteur à base de SiₓGe₁₋ₓ, avec x > 0, les blocs semi-conducteurs ayant des facettes latérales réalisant un angle non-nul avec une normale à la couche semi-conductrice superficielle, les facettes latérales définissant des cavités entre les facettes et les espaceurs isolants,
- dépôt, en particulier par croissance d'une couche en silicium sur les blocs semi-conducteurs, de manière à remplir les cavités situées entre les facettes et les espaceurs isolants,
- oxydation thermique des blocs semi-conducteurs et de la couche de silicium, de sorte à réaliser un enrichissement en germanium d'une partie de la couche semi-conductrice superficielle, cette partie étant disposée autour du canal et des espaceurs.

Du fait de la présence de la couche en silicium et de son agencement par rapport aux blocs semi-conducteurs à base de SiₓGe₁₋ₓ, on obtient à l'issue de l'oxydation thermique, un enrichissement en germanium desdites portions sans phénomène de pincement intempestif voire même sans que l'épaisseur de ces portions ne soit réduite par rapport aux régions d'accès au canal. Cela permet ainsi de limiter les résistances d'accès, d'appliquer une meilleure contrainte à la structure de canal et de favoriser une reprise d'épitaxie ultérieure lors de la réalisation des blocs de source et de drain.

Avantageusement, le dépôt de la couche en silicium sur les blocs semi-conducteurs est réalisé de manière à remplir entièrement lesdites cavités.

Avantageusement, la croissance du deuxième matériau semi-conducteur à base de SiₓGe₁₋ₓ est réalisée sans dopage. Ainsi, les blocs semi-conducteurs ne sont pas dopés lorsque l'oxydation thermique est effectuée.

Avantageusement, la croissance de la couche à base de silicium sur les blocs semi-conducteurs, est réalisée sans dopage. Ainsi, la couche à base de silicium n'est pas dopée lorsque l'oxydation thermique est effectuée.

Le deuxième matériau semi-conducteur peut être différent du premier matériau semi-conducteur et avoir un paramètre de maille différent de celui du premier matériau semi-conducteur.

Selon une mise en œuvre particulière du procédé pour laquelle l'oxydation thermique conduit à la formation d'une couche d'oxyde sur les blocs semi-conducteurs, le procédé peut comprendre en outre des étapes de :
- retrait de la couche d'oxyde,
- croissance de matériau semi-conducteur sur les portions semi-conductrices de la couche semi-conductrice superficielle disposées de part et d'autre des espaceurs. Des blocs de source et de drain peuvent être ainsi réalisés à partir des blocs à base du deuxième matériau semi-conducteur. Avantageusement, un dopage *in situ* est effectué lors de la croissance de matériau semi-conducteur sur les portions semi-conductrices de la couche semi-conductrice superficielle.

Selon un mode de réalisation particulier, après l'oxydation thermique, on effectue au moins un recuit thermique sous atmosphère neutre, de sorte à homogénéiser la concentration en Germanium des portions semi-conductrices.

Le transistor réalisé est typiquement un transistor de type P. Les portions semi-conductrices enrichies en Germanium permettent alors d'exercer une contrainte en compression sur la région donnée dans laquelle la structure de canal est prévue.

### BRÈVE DESCRIPTION DES DESSINS

La présente invention sera mieux comprise sur la base de la description qui va suivre et des dessins en annexe sur lesquels :
La figure 1 sert à illustrer un phénomène de pincement intempestif de régions semi-conductrices à proximité des espaceurs suite à la mise en œuvre d'un procédé d'enrichissement germanium tel que mis en œuvre suivant l'art antérieur ;
Les figures 2A, 2B, 2C, 2D, 2E, 2F, 2G servent à illustrer un exemple de procédé suivant un mode de réalisation de l'invention visant à la fabrication de régions enrichies en Germanium de part et d'autre d'une région destinée à former une structure de canal de transistor.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation d'une structure tels que « avant », « supérieure », « arrière », « inférieure », « latérale », s'appliquent en considérant que la structure est orientée de la façon illustrée sur les figures.

### EXPOSÉ DÉTAILLÉ DE MODES DE RÉALISATION PARTICULIERS

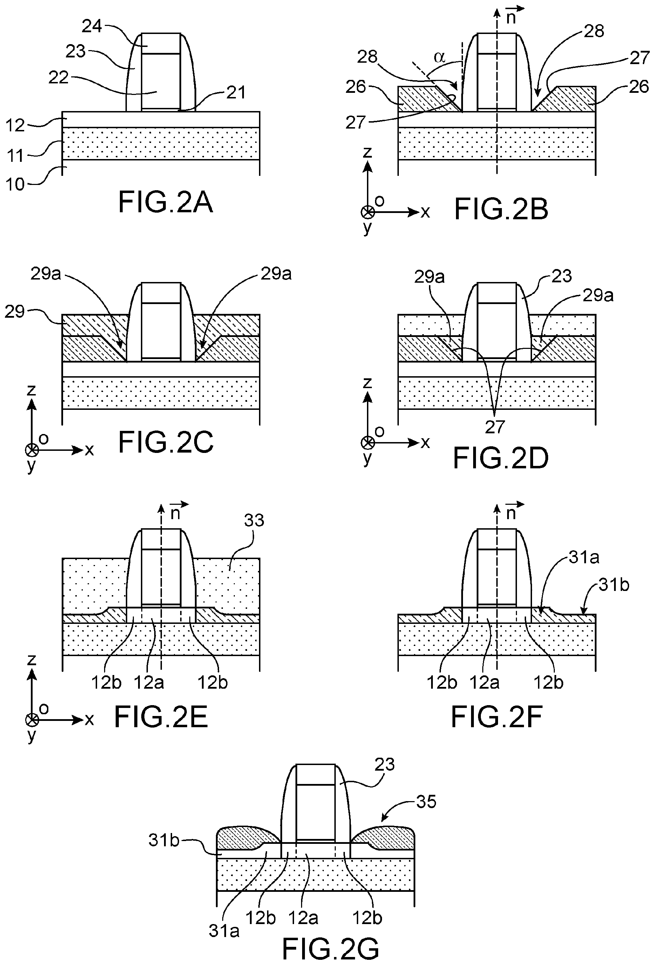

Une structure de départ possible, pour mettre en œuvre un procédé suivant un mode de réalisation de la présente invention, est donnée sur la figure 2A.

Cette structure comprend un substrat de type semi-conducteur sur isolant, avec une couche de support 10 semi-conductrice, typiquement en silicium, une couche isolante 11 d'oxyde de silicium agencée sur la couche de support 10 et une couche semi-conductrice superficielle 12 disposée sur et en contact avec la couche isolante 11 et prévue pour accueillir au moins une région de canal d'un transistor, en particulier un transistor de type P, par exemple un PMOS.

La couche semi-conductrice superficielle 12 est à base d'un premier matériau semi-conducteur, typiquement du silicium, le substrat pouvant être alors de type SOI (« Silicon On Insulator » ou « Silicium sur Isolant »). Dans ce cas, on utilise de préférence du silicium d'orientation <110> pour la couche semi-conductrice superficielle 12. En variante, on peut prévoir la couche semi-conductrice superficielle 12 en Si₁₋ₐGeₐ avec a par exemple compris entre 0.05 et 0.80 et typiquement entre 0.2 et 0.5, de préférence entre 0.2 et 0.3.

Avantageusement, le substrat peut être prévu pour accueillir des transistors en technologie totalement déplétée, en particulier FDSOI (pour « Fully Depleted Silicon on Insulator » ou « silicium sur isolant totalement déplétée »). La couche semi-conductrice superficielle 12 peut être ainsi prévue avec une épaisseur par exemple comprise entre 2 nm et 20 nm, avantageusement en 2 nm et 16 nm et typiquement de l'ordre de 8 nm.

Dans l'exemple illustré, un diélectrique 21 de grille, un bloc 22 de grille du transistor 12, et des espaceurs 23 de part et d'autre du bloc 22 de grille sont déjà formés. Le bloc 22 de grille peut être ici destiné à former l'électrode de grille définitive du transistor.

Le bloc 22 de grille peut être par exemple à base de polysilicium ou de TiN ou de W ou bien d'une combinaison de ces matériaux. Les espaceurs 23 peuvent être par exemple à base de SiN ou de SiCO ou de SiBCN ou de SiOCN ou d'une combinaison de ces matériaux. Dans l'exemple de réalisation particulier illustré, le bloc 22 de grille est également surmonté d'au moins un masque dur 24 par exemple formé d'une couche en SiN et/ou en SiO₂.

En variante, on peut utiliser un bloc de grille sacrificiel ou factice destiné ultérieurement à être retiré puis remplacé par une grille définitive.

On fait ensuite croitre par épitaxie sur le premier matériau semi-conducteur de ladite couche semi-conductrice superficielle 12, un deuxième matériau semi-conducteur, contenant du Germanium, et qui est destiné à réaliser un enrichissement en Germanium de la couche superficielle 12.

Le deuxième matériau semi-conducteur peut être différent du premier matériau semi-conducteur et avoir un paramètre de maille différent de celui du premier matériau semi-conducteur. Le deuxième matériau semi-conducteur peut être à base de Si₁₋ₓGeₓ avec x>0. La concentration x en Germanium est comprise par exemple entre 0.05 et 0.80 et typiquement entre 0.2 et 0.5, de préférence telle que x>a lorsque le premier matériau semi-conducteur est du Si₁₋ₐGeₐ.

Comme cela est visible en figure 2B, la croissance du deuxième matériau semi-conducteur sur le premier matériau semi-conducteur est typiquement réalisée de sorte à former des blocs 26 du deuxième matériau semi-conducteur ayant des facettes latérales 27 réalisant un angle α non-nul avec une normale n à un plan principal de la couche superficielle (i.e. un plan passant par la couche superficielle et parallèle au plan [O ; x; y] du repère orthogonal [O ; x ; y ; z] donné sur la figure 2B). La croissance épitaxiale de ce deuxième matériau est effectuée de préférence sans dopage *in situ* de sorte que les blocs 26 ne sont pas dopés à cette étape du procédé.

Un nettoyage préalable à l'épitaxie peut être effectué pour optimiser la surface sur laquelle on réalise la croissance. Par exemple, un tel nettoyage est effectué à l'aide d'un procédé de type appelé « HFlast » comportant une séquence de préparation de surface de Si dans laquelle une gravure à l'aide de HF d'un oxyde natif est effectuée à la fin de la séquence, ce afin de laisser la surface des liaisons d'hydrogène. Un autre exemple de méthode de préparation de surface emploie un procédé de type SiConi^{™}. Un tel procédé utilise une gravure à sec assistée par plasma. L'épitaxie de SiGe facetté pour réaliser les blocs 26 peut être effectuée en utilisant des précurseurs de type GeH₄+HCl à une température par exemple de l'ordre de 650°C. L'épaisseur crue peut être comprise par exemple entre 4 nm et 10 nm.

Les blocs 26 sont formés par épitaxie sélective sans recouvrir les espaceurs 23 ou la grille 22.

Les facettes latérales 27 ont une extrémité située au pied des espaceurs 23. De par l'agencement des facettes 27 par rapport aux espaceurs 23, des espaces ou cavités 28 sont agencé(e)s entre les espaceurs 23 et les facettes 27 des blocs 26 du deuxième matériau semi-conducteur.

Comme cela est illustré sur la figure 2C, on vient ensuite combler au moins partiellement ces cavités 28 à l'aide d'une couche semi-conductrice 29. La couche semi-conductrice 29 est réalisée par dépôt, en particulier par croissance épitaxiale sur les blocs 26. La couche 29 est à base d'un matériau différent de celui des blocs semi-conducteurs 26 et en particulier avec une concentration en germanium inférieure à celle des blocs semi-conducteurs 26. Le matériau semi-conducteur de la couche 29 est de préférence choisi de manière à pouvoir croitre sans réaliser de facette. Ainsi, le matériau semi-conducteur de la couche 29 peut être du silicium. La formation de cette couche 29 peut être telle que des portions peuvent s'étendre sur des faces supérieures des blocs 26. La croissance de ce matériau peut être éventuellement réalisée de sorte que des portions 29a de la couche 29 viennent remplir entièrement les cavités 28 (figure 2C).

La couche semi-conductrice 29 est formée de manière sélective sans recouvrir la grille 22. Cette croissance épitaxiale de la couche semi-conductrice 29 est effectuée de préférence sans dopage *in situ.*

On vient ensuite réaliser un enrichissement en Germanium de la couche semi-conductrice superficielle 12 par le Germanium des blocs 26. Un tel enrichissement peut être effectué par exemple à l'aide d'un procédé d'oxydation tel que décrit dans le document: « A novel fabrication technique of ultrathin and relaxed SiGe buffer layers with high Ge fraction for sub-100 nm strained silicon on insulator MOSFETs, Tezuka et al., Japanese Journal of Applied Physics, vol. 40, p 2866-2874, 2001 » ou dans le document « Selectively formed high mobility SiGe on Insulator pMOSFETs with Ge-rich strained surface channels using local condensation technique, Tezuka et al., Symposium on VLSI Technology, 2004 ». Pour effectuer la condensation de Ge, au moins une première étape d'oxydation thermique est réalisée à une température de préférence élevée mais inférieure à la température de fusion du matériau Si₁₋ₓGeₓ, typiquement à une température comprise entre 750°C et 1100°C. Le couple durée/température d'oxydation dépend de l'épaisseur de la couche que l'on souhaite oxyder. Par exemple, on peut prévoir de réaliser l'oxydation à une température de 900°C pendant une durée de l'ordre de 5 min, ou bien à une température de 1050°C pendant une durée de l'ordre de 20s, pour une couche d'épaisseur de l'ordre de 6 nm de SiGe avec une concentration en Germanium de l'ordre de 30%.

Durant l'étape d'oxydation, le silicium de la couche 29 a tendance à se consommer, de manière à former du SiO₂. Un front d'oxydation horizontal autrement dit parallèle au plan [O ;x ;y] donné sur la figure 2D se propage et atteint la face supérieure des blocs 26.

Sur la figure 2D (illustrant la structure en cours d'oxydation), l'oxydation de toute l'épaisseur de portions de la couche 29 située sur les faces supérieures de blocs 26 tandis que d'autres portions 29a de la couche 29 qui viennent remplir les cavités 28 et séparent les facettes latérales 27 des espaceurs 23 ne sont pas encore oxydées. Les blocs semi-conducteurs 26 et les portions 29a ont ensuite des vitesses d'oxydation différentes du fait de leurs proportions respectives différentes en silicium, comme cela est décrit dans le document : « Si et SiGe : SiGe oxidation kinetics and oxide density measured by resonant soft X-ray reflectivity », Rozé et al., Nanotechnology Material and Devices Conférence 2017. L'oxydation est poursuivie sur toute l'épaisseur des blocs 26 puis de préférence de manière à oxyder les portions 29a.

Du fait de l'absence de dopage des blocs 26 et de la couche semi-conductrice 29, il n'y a pas de diffusion intempestive de dopants durant l'oxydation thermique.

Du fait de l'agencement des blocs 26 et de la couche semi-conductrice 29, la concentration en Germanium est favorisée dans des portions 12a de la couche superficielle 12 plus éloignées que celles directement voisines des régions d'accès 12b (figure 2E). Du fait que la vitesse d'oxydation dépend de la teneur en Germanium, avec un tel agencement on évite un effet de pincement tel qu'évoqué précédemment et illustré sur la figure 1, susceptible de provoquer une discontinuité de la couche semi-conductrice superficielle 12 et en tout cas d'augmenter les résistances d'accès au canal.

Les portions 31a de composition en germanium inférieure ont même typiquement une épaisseur plus importante que celle de parties 31b plus éloignées de la structure de canal et peuvent être réalisées avec une épaisseur au moins égale voire supérieure à celle des régions 12b d'accès et de la structure 12a de canal.

Une telle forme convexe des régions 12b présente pour avantage de favoriser la mise en contrainte de la structure de canal lorsque l'on réalise ensuite sur ces régions 12b une épitaxie afin de compléter la formation des blocs de source et de drain. Une telle forme des régions 12b permet également de réaliser un meilleur profil de dopage des blocs de source et de drain.

Du fait de l'enrichissement en germanium opéré on réalise toutefois une mise en contrainte de la région semi-conductrice 12a-12b située en regard de la grille 22 et des espaceurs 23 et par conséquent de la structure 12a de canal du transistor.

De manière optionnelle, on peut ensuite réaliser au moins une étape de traitement thermique supplémentaire, cette fois de préférence sous atmosphère neutre, afin d'homogénéiser la concentration en Germanium de portions semi-conductrices en silicium germanium réalisées de part et d'autre des espaceurs et des régions d'accès 12b au canal 12a. Un tel recuit peut être effectué à une température comprise entre 800°C et 1000°C selon une durée comprise par exemple entre 2min et 2h par exemple un recuit à une température de l'ordre de 900°C pendant une durée de l'ordre de 2heures peut être effectué.

Une désoxydation afin de retirer une épaisseur d'oxyde 33 formée lors de la condensation en Germanium peut être ensuite effectuée (figure 2F). On peut effectuer ce retrait par exemple à l'aide de HF dilué, avec une teneur par exemple de 1%.

On peut ensuite poursuivre la fabrication du transistor et en particulier compléter la formation de blocs de source et de drain.

Pour cela, on peut faire croitre par épitaxie des régions semi-conductrices 35 de part et d'autre des espaceurs 23 depuis les portions semi-conductrices 31a, 31b (figure 2G). De préférence, on choisit un matériau semi-conducteur susceptible de favoriser une contrainte en compression dans la structure de canal. Typiquement les régions semi-conductrices 35 sont en Silicium Germanium, de préférence dopé, par exemple au Bore. Un dopage *in situ* effectué pendant la croissance du matériau semi-conducteur peut être effectué. Une dose par exemple de l'ordre de 1^{e}20 at*cm⁻³ peut être par exemple employée.

On peut ensuite également réaliser des contacts sur les régions de source, de drain et éventuellement sur la grille par formation de zones de composé et de métal sur ces régions afin de compléter la fabrication du transistor.

D'autres étapes de fabrication conventionnelles de formation d'une encapsulation isolante et de fabrication de plots de contact peuvent être ensuite réalisées.

Un transistor de type P formé dans la couche semi-conductrice superficielle enrichie en Germanium d'un substrat de type semi-conducteur sur isolant s'adapte tout particulièrement à la mise en œuvre de circuits à faible consommation (« Low Power ») et hautes performances (« high performance »).

## Revendications

1. Procédé de réalisation d'une structure de transistor comprenant, dans cet ordre, les étapes suivantes :
- fournir un bloc (22) de grille et des espaceurs isolants (23) de part et d'autre du bloc de grille sur une région (12a, 12b) donnée d'une couche semi-conductrice superficielle (12) d'un substrat de type semi-conducteur sur isolant, la couche semi-conductrice superficielle étant à base d'un premier matériau semi-conducteur, en particulier du Si ou du Si₁₋ₐGeₐ avec a > 0, la région donnée (12a, 12b) étant apte à accueillir une structure (12a) de canal dudit transistor en regard dudit bloc de grille,
- former sur ladite couche semi-conductrice superficielle et de part et d'autre des espaceurs, des blocs semi-conducteurs (26) par croissance d'un deuxième matériau semi-conducteur à base de SiₓGe₁₋ₓ, avec x > 0, les blocs semi-conducteurs ayant des facettes latérales (27) réalisant un angle non-nul avec une normale (n) à la couche semi-conductrice superficielle (12), les facettes latérales (27) définissant des cavités (28) entre lesdites facettes (27) et lesdits espaceurs isolants (23),
- dépôt d'une couche (29) en silicium sur les blocs semi-conducteurs (26), de manière à remplir les cavités (28) situées entre lesdites facettes (27) et lesdits espaceurs isolants (23), le dépôt de la couche (29) en silicium sur les blocs semi-conducteurs (26) étant réalisé de manière à remplir entièrement lesdites cavités (28),
- oxydation thermique desdits blocs semi-conducteurs (26) et de ladite couche (29) de silicium, de sorte à réaliser un enrichissement en germanium d'une partie de la couche semi-conductrice superficielle (12), ladite partie étant disposée autour du canal et des espaceurs (23).

2. Procédé selon la revendication 1, dans lequel la croissance dudit deuxième matériau semi-conducteur à base de SiₓGe₁₋ₓ est réalisée sans dopage, lesdits blocs semi-conducteurs (26) n'étant pas dopés lorsque ladite oxydation thermique est effectuée.

3. Procédé selon l'une des revendications 1 ou 2, dans lequel le dépôt de de ladite couche (29) à base de silicium sur les blocs semi-conducteurs (26), est réalisé sans dopage, ladite couche (29) à base de silicium n'étant pas dopée lorsque de ladite oxydation thermique est effectuée.

4. Procédé selon l'une des revendications 1 à 3, dans lequel ladite oxydation thermique conduit à la formation d'une couche d'oxyde (33) sur lesdits blocs semi-conducteurs (26), le procédé comprenant en outre des étapes de :
- retrait de ladite couche d'oxyde (33),
- croissance de matériau semi-conducteur sur des portions semi-conductrices (31a, 31b) de la couche semi-conductrice superficielle (12) disposées de part et d'autre des espaceurs (23).

5. Procédé selon la revendication 4, dans lequel un dopage *in situ* est effectué lors de ladite croissance de matériau semi-conducteur sur lesdites portions semi-conductrices (31a, 31b) de la couche semi-conductrice superficielle (12).

6. Procédé selon l'une des revendications 4 ou 5, dans lequel après ladite oxydation thermique, on effectue au moins un recuit thermique sous atmosphère neutre, de sorte à homogénéiser la concentration en Germanium desdites portions semi-conductrices (31a, 31b) de la couche semi-conductrice superficielle (12).

7. Procédé selon l'une des revendications 1 à 6, le deuxième matériau semi-conducteur ayant un paramètre de maille différent de celui du premier matériau semi-conducteur.

8. Procédé selon l'une des revendications 4 à 6, dans lequel le transistor est de type P, lesdites portions semi-conductrices (31a, 31b) formées par enrichissement de Germanium exerçant une contrainte en compression sur ladite région donnée.
